# EUROPÄISCHE PATENTSCHRIFT

(11) **EP 1 022 507 B1**
(45) Veröffentlichungstag und Bekanntmachung des Hinweises auf die Patenterteilung: **26.04.2006**
(21) Anmeldenummer: 99125880.7
(22) Anmeldetag: 24.12.1999
(51) Int. Cl.: F16M 1/00

(54) **Verschlussdeckel**
Close cover
Couvercle de fermenture

(30) Priorität: 21.01.1999 DE 19902283
(43) Veröffentlichungstag der Anmeldung: 26.07.2000
(73) Patentinhaber: Carl Freudenberg KG, 69469 Weinheim (DE)
(72) Erfinder: Unger, Hans, 69518 Absteinach (DE)

(56) Entgegenhaltungen:
- DE-A- 2 718 563
- DE-A- 3 107 694
- DE-A- 3 229 830
- DE-B- 1 273 286
- US-A- 2 003 769

## Beschreibung

### Technisches Gebiet

Die Erfindung betrifft einen Verschlußdeckel zum dichten VerschlieBen einer Durchbrechung in einem Gehäuse, umfassend einen Stützkörper, der auf der der Begrenzungswand der Durchbrechung zugewandten Seite mit zumindest einem Dichtring verbunden ist, wobei der Dichtring zum Ausgleich von Vofuranenändenrngen im vom Gehäuse umschlossenen, abzudichtenden Raum einstückig ineinander übergehend mit einer Membran ausgebildet ist, wobei der Stützkörper, der Dichtring und die Membran eine vormontierbare Einheit büden, wobei der Dichtring und die Membran materialeinheitlich ausgebildet sind, wobei die Membran auf der dem abzudichtenden Raum abgewandten Seite von einem Deckel überdeckt ist und wobei der Deckel und die Einheit kraft- und/oder formschlüssig miteinander verbunden sind.

### Stand der Technik

Derartige Verschlußdeckel sind allgemein bekannt. Das Gehäuse kann beispielsweise als Motorblock einer Verbrennungskraftmaschine oder als Getriebegehäuse ausgebildet sein. Starke Temperaturschwankungen innerhalb des hermetisch abgedichteten Gehäuses bedingen bei konstantem Volumen Druckänderungen. Durch die aus den Druckänderungen resultierenden, sich entsprechend ändernden Kräfte besteht die Gefahr von Verlagerung des Verschlußdeckels in der Durchbrechung und/oder eines Verlusts des Verschlußdeckels aus der Durchbrechung

Aus der DE-A-3107694 ist ein Verschlußdeckel bekannt, bei dem der Deckel mit der Einheit durch eine Umbördelung permanent verbunden ist. Die US-A-2003769 offenbart einen Verschlußdeckel, welcher einen Deckel aufweist, der mit einer Einheit verschraubt ist

### Darstellung der Erfindung

Der Erfindung liegt die Aufgabe zugrunde, einen VerschluBdeckel zu realisieren, der eine einfache Montage und Demontage seiner Einzelteile bei einfacher Fertigung erlaubt

Diese Aufgabe wird erfindungsgemäß mit den Merkmalen von Anspruch 1 gelöst. Danach ist der Verschlußdeckel, welcher die zuvor aufgezeigt Aufgabe löst, dadurch gekennzeichnet, daß der Dichtririg und die Membran aus einem elastomeren Werkstoff bestehen und der außenumfangsseitige Rand des Deckels in eine Hinterschneidung des elastomeren Werkstoffs der vormontierbaren Einheit einschnappbar ist Auf vorteilhafte Ausgestaltungen nehmen die Unteransprüche Bezug.

Der Dichtring ist zum Ausgleich von Volumenänderungen im vom Gehäuse umschlossenen, abzudichtenden Raum einstückig ineinander übergehend mit einer Membran ausgebildet. Bei einer derartigen Ausgestaltung ist von Vorteil, daß die Membran beispielsweise temperaturbedingte Volumenänderungen innerhalb des abzudichtenden Raums auszugleichen vermag. Der Druck innerhalb des abzudichtenden Raums bleibt dabei im wesentlichen konstant. Durch die einstückige Ausgestaltung des Dichtrings mit der Membran ist das Einknüpfen einer separat erzeugten Membran entbehrlich, was in fertigungstechnischer und wirtschaftlicher Hinsicht von hervorzuhebendem Vorteil ist. Die Herstellung und Handhabung des VerschluBdeckels ist wesentlich vereinfacht und die Gefahr von Montagefehlem ist auf ein Minimum begrenzt.

Eine weitere Vereinfachung in der Herstellung des VerschluBdeckels ist erreicht, wenn der Dichtring und die Membran materialeinheitlich ausgebildet sind. Der Dichtring und die Membran bestehen aus einem elastomeren Werkstoff.

Zum Schutz vor äußeren Einflüssen und/oder Beschädigungen ist die Membran auf der dem abzudichtenden Raum abgewandten Seite von einem Deckel überdeckt.

Der Deckel und die vormontierbare Einheit sind kraut- und/oder formschlüssig miteinander verbunden.

Im Hinblick auf eine einfache Montage und Demontage des Deckels ist der außenumfangseitige Rand des Deckels in eine Hinterschneidung des elastomeren Werkstoffs der vormontierbaren Einheit eingeschnappt.

Der Stützkörper kann aus einem zähharten Werkstoff bestehen. Bevorzugt besteht der Stützkörper aus einem metallischen Werkstoff, beispielsweise einem zylinderförmigen Blech, das im Bereich einer seiner beiden Stimseiten in radialer Richtung nach innen umgebördett ist. Die radial nach innen umgebördette Stirnseite des Stützkörpers ist auf der dem abzudichtenden Raum abgewandten Seite des Stützkörpers angeordnet.

Die Membran kann herstellungsbedingt in Richtung des abzudichtenden Raums vorgewölbt sein. Steigt die Temperatur innerhalb des abzudichtenden Raums betriebsbedingt an, verformt sich die Membran zum Ausgleich von Volumenänderungen so, daß der Druck innerhalb des abzudichtenden Raums im wesentlichen konstant bleibt. Bei einer anschließenden Abkühlung federt sich die elastisch verformte Membran wieder in ihre herstellungsbedingte Form zurück.

Die Membran ist bevorzugt rollbalgartig ausgebildet. Hierbei ist von Vorteil, daß große Volumenänderungen innerhalb des hermetisch abgedichteten Gehäuses problemlos ausgeglichen werden können.

Der Stützkörper, der Dichtring und die Membran bilden eine vormontierbare Einheit. Die Herstellung dieser Einheit erfolgt derart, daß der Stützkörper in ein Werkzeug eingelegt und von elastomerem Werkstoff umspritzt wird. Im Anschluß an die Abkühlung und Verfestigung ist der Stützkörper unlösbar mit dem Dichtring und der Membran verbunden, wobei der Dichtring und die Membran einstückig ineinander übergehend ausgebildet sind.

Der Stützkörper ist bevorzugt vollständig von elastomerem Werkstoff umschlossen. Dies ist insbesondere dann sinnvoll, wenn der Stützkörper aus einem metallischen Werkstoff besteht. Durch die vollständige Ummantelung des Stützkörpers mit elastomerem Werkstoff wird ein ausgezeichneter Korrosionsschutz erreicht.

Die Stirnseite des Deckels ist auf der dem abzudichtenden Raum abgewandten Seite bevorzugt mit der entsprechenden Stirnseite der vormontierbaren Einheit in einer Radialebene angeordnet. Durch den glatten, stirnseitigen Abschluß des Verschlußdeckels kann die Durchbrechung im Gehäuse oberflächenbündig verschlossen werden, so daß die Anlagerung von Verunreinigungen ausgeschlossen ist.

Um einen guten Volumenausgleich durch die Membran zu gewährleisten, weist der Deckel zumindest eine Entlüftungsöffnung auf. Die Entlüftungsöffnung verbindet den Hohlraum, der von der Membran und dem Deckel begrenzt ist, strömungsleitend mit der Atmosphäre.

Der Druck innerhalb des abzudichtenden Raums bleibt dadurch im wesentlichen konstant, unabhängig vom Betriebszustand und der Auslenkung der Membran.

Der Deckel besteht bevorzugt aus einem polymeren Werkstoff. Die Korrosionsbeständigkeit und das geringe Gewicht sind bei einem Deckel aus derartigem Material besonders vorteilhaft.

### Kurzbeschreibung der Zeichnungen

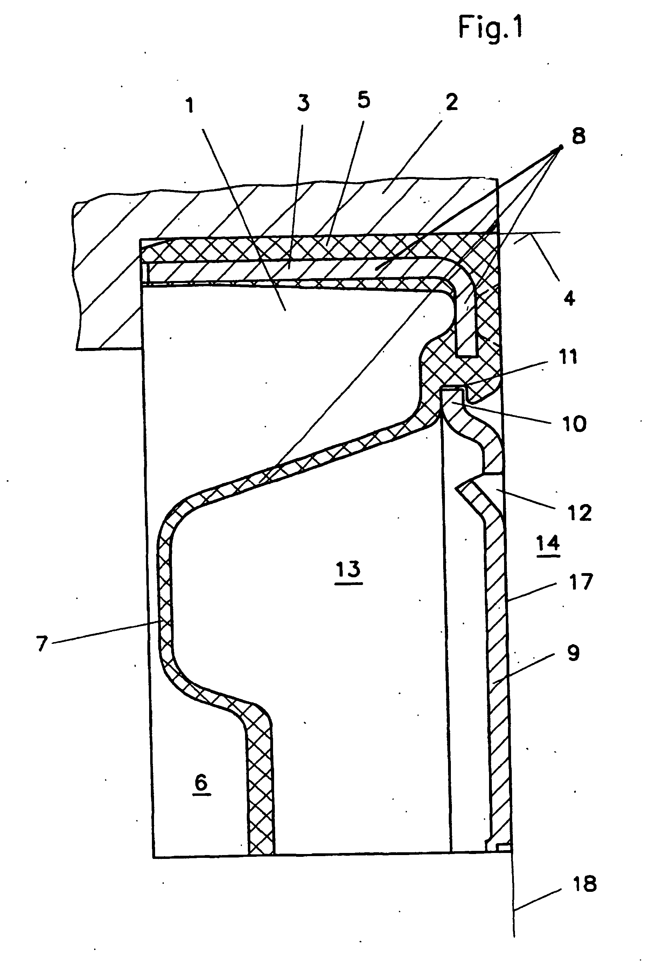

Der erfindungsgemäße Verschlußdeckel wird nachfolgend anhand der Figuren 1 bis 3 näher beschrieben.

Diese zeigen: jeweils ein Ausführungsbeispiel in längsgeschnittener Darstellung.

### Ausführung der Erfindung

In den Figuren 1 bis 3 ist jeweils ein Verschlußdeckel gezeigt, der dichtend in eine Durchbrechung 1 eines Gehäuses 2 eingesetzt ist. Der Stützkörper 3 besteht jeweils aus einem metallischen Werkstoff, während der Dichtring 5 und die einstückig mit dem Dichtring 5 ausgebildete Membran 7 jeweils aus elastomerem Werkstoff bestehen.

Der Dichtring 5 berührt die Begrenzungswand 4 der Durchbrechung 1 unter elastischer Vorspannung dichtend.

Innerhalb des hermetisch abgedichteten Raums 6 entstehen während der bestimmungsgemäßen Verwendung des Verschlußdeckels unterschiedliche Temperaturen, wobei der Druck innerhalb des abzudichtenden Raums 6 stets im wesentlichen gleichbleiben soll. Um diese Voraussetzung zu erfüllen, ist es erforderlich, daß die Membran 7 einen Volumenausgleich des von dem Gehäuse umschlossenen Mediums zuläßt.

In jedem der Ausführungsbeispiele ist die Membran 7 in Richtung des abzudichtenden Raums 6 vorgewölbt und auf der dem abzudichtenden Raum 6 abgewandten Seite von einem Deckel 9 überdeckt.

Der Deckel 9 ist in jedem der Ausführungsbeispiele formschlüssig in die Hinterschneidung 11 des elastomeren Werkstoffs eingeschnappt und weist zumindest eine Entlüftungsöffnung 12 auf, die den Hohlraum 13, der von der Membran 7 und dem Deckel 9 begrenzt ist, mit der Atmosphäre 14 verbindet. In Figur 1 ist ein erstes Ausführungsbeispiel des erfindungsgemäßen Verschlußdeckels gezeigt. Der Stützkörper 3 ist vollständig von elastomerem Werkstoff umschlossen. Die Membran 7 ist im wesentlichen rollbalgartig ausgebildet.

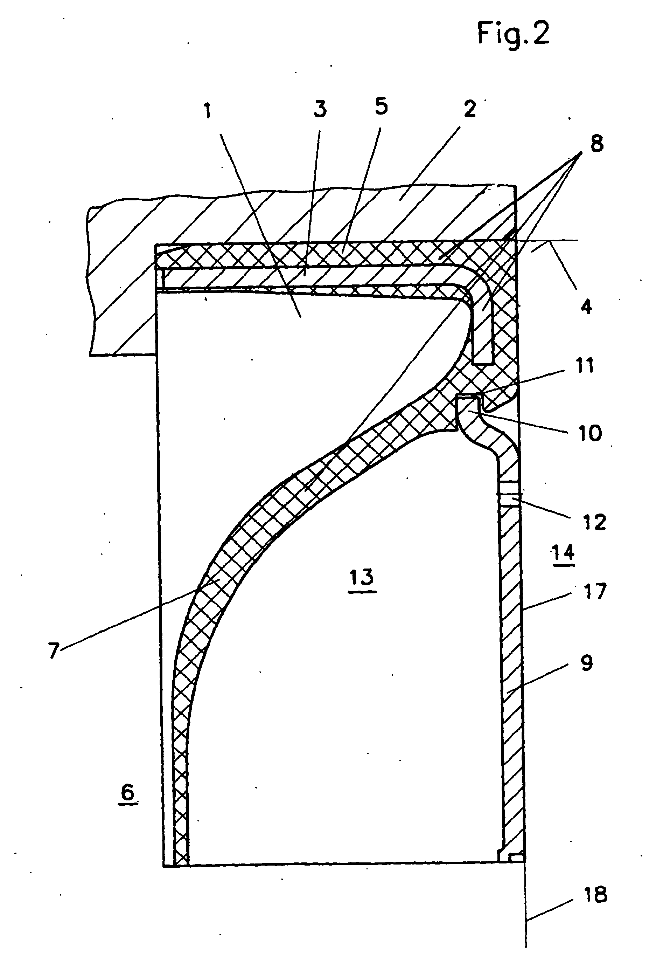

Das Ausführungsbeispiel aus Figur 2 unterscheidet sich von dem zuvor beschriebenen im wesentlichen durch die Ausgestaltung der Membran 7 und dadurch, daß die Entlüfungsöffnung 12 durch eine Bohrung im Deckel 9 gebildet ist.

Die Membran 7 ist im Vergleich zur Membran 7 aus Figur 1 in axialer Richtung steifer und kann zum Volumenausgleich nur einen vergleichsweise geringeren Weg in axialer Richtung zurücklegen.

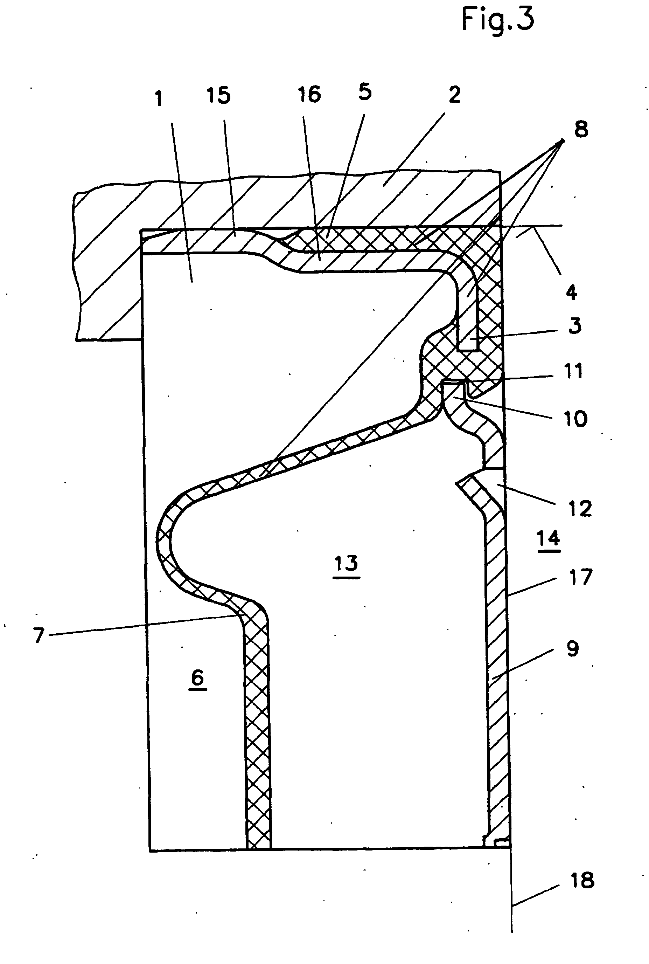

Das Ausführungsbeispiel aus Figur 3 unterscheidet sich von den vorherigen Ausführungsbeispielen im wesentlichen dadurch, daß der Stützkörper 3 auf der dem abzudichtenden Raum 6 zugewandten Seite radial nach außen gekröpft ist. Die Außenumfangsfläche des radial nach außen gekröpften Teils 15 berührt die Durchbrechung 1 des Gehäuses 2 unmittelbar anliegend, so daß in Verbindung mit dem Volumenausgleich eine stets sichere, unverrückbare Festlegung des Verschlußdeckels gewährleistet ist. Nachteilige Relaxaktionserscheinungen sind bei dieser Ausführung ausgeschlossen.

Der Dichtring 5 umschließt nur den zurückversetzten Teil 16 außenumfangsseitig und dichtet den Verschlußdeckel gegenüber dem Gehäuse 2 ab. Die Membran 7 ist im wesentlichen ähnlich rollbalgartig ausgebildet, wie die Membran 7 aus Figur 1. Durch rollbalgartig ausgebildete Membranen 7 kann der abzudichtende Raum 6 im wesentlichen drucklos Volumen aufnehmen, das beispielsweise durch eine Temperaturerhöhung des hermetisch eingeschlossenen Mediums innerhalb des abzudichtenden Raums 6 entsteht.

In jedem der drei Ausführungsbeispiele schließt die dem abzudichtenden Raum 6 abgewandte Stirnseite des Verschlußdeckels bündig mit dem Gehäuse 2 ab; die stirnseitige Begrenzung des Gehäuses 2 und die Stirnseite 17 sind in einer Radialebene 18 angeordnet.

## Patentansprüche

1. Verschlußdeckel zum dichten Verschließen einer Durchbrechung (1) in einem Gehäuse (2), umfassend einen Stützkörper (3), der auf der der Begrenzungswand der Durchbrechung (1) zugewandten Seite mit zumindest einem Dichtring (5) verbunden ist, wobei der Dichtring (5) zum Ausgleich von Volumenänderungen im vom Gehäuse (2) umschlossenen, abzudichtenden Raum (6) einstückig ineinander übergehend mit einer Membran (7) ausgebildet ist, wobei der Stützkörper (3), der Dichtring (5) und die Membran (7) eine vormontierbare Einheit (8) bilden, wobei der Dichtring (5) und die Membran (7) materialeinheitlich ausgebildet sind, wobei die Membran (7) auf der dem abzudichtenden Raum (6) abgewandten Seite von einem Deckel (9) überdeckt ist und wobei der Deckel (9) und die Einheit (8) kraft- und/oder formschlüssig miteinander verbunden sind, **dadurch gekennzeichnet**, daB der Dichtring (5) und die Membran (7) aus einem elastomeren Werkstoff bestehen und der außenumfangsseitige Rand des Deckels (9) in eine Hinterschneidung (11) des elastomeren Werkstoffs der vormontierbaren Einheit (8) einschnappbar ist.

2. Verschlußdeckel nach Anspruch 1, **dadurch gekennzeichnet, daß** der Stützkörper (3) aus einem zähharten Werkstoff besteht.

3. Verschlußdeckel nach Anspruch 2, **dadurch gekennzeichnet, daß** der Stützkörper (3) aus einem metallischen Werkstoff besteht.

4. Verschlußdeckel nach einem der Ansprüche 1 bis 3, **dadurch gekennzeichnet, daß** die Membran (7) herstellungsbedingt in Richtung des abzudichtenden Raums (6) vorgewölbt ist

5. Verschlußdeckel nach einem der Ansprüche 1 bis 4, **dadurch gekennzeichnet, daß** die Membran (7) rollbalgartig ausgebildet ist.

6. Verschlußdeckel nach einem der Ansprüche 1 bis 5, **dadurch gekennzeichnet, daß** der Deckel (9) zumindest eine Entlüftungsöffnung (12) aufweist.

7. VerschluBdeckel nach einem der Ansprüche 1 bis 6, **dadurch gekennzeichnet, daß** der Deckel (9) aus einem polymeren Werkstoff besteht.

## Revendications

1. Couvercle de fermeture pour fermer de manière étanche une perforation (1) dans un boîtier (2), qui présente un corps de soutien (3) dont le côté orienté vers la paroi qui délimite la perforation (1) est relié à au moins un anneau d'étanchéité (5), l'anneau d'étanchéité (5) étant réalisé de manière à être prolongé d'un seul tenant par une membrane (7) pour compenser les variations de volume de l'espace (6) entouré par le boîtier (2) et qu'il faut fermer de manière étanche, le corps de soutien (3), l'anneau d'étanchéité (5) et la membrane (7) formant une entité prémontable (8), l'anneau d'étanchéité (5) et la membrane (7) étant réalisés dans le même matériau, le côté de la membrane (7) qui n'est pas orienté vers l'espace (6) à fermer de manière étanche étant recouvert par un couvercle (9), le couvercle (9) et l'entité (8) étant reliés l'un à l'autre en correspondance mécanique et/ou en correspondance géométrique, **caractérisé en ce que** l'anneau d'étanchéité (5) et la membrane (7) sont constitués d'un matériau élastomère et **en ce que** le bord périphérique extérieur du couvercle (9) peut être encliqueté dans une contre-dépouille (11) du matériau élastomère de l'entité prémontable (8).

2. Couvercle de fermeture selon la revendication 1, **caractérisé en ce que** le corps de soutien (3) est constitué d'un matériau dur et tenace.

3. Couvercle de fermeture selon la revendication 2, **caractérisé en ce que** le corps de soutien (3) est constitué d'un matériau métallique.

4. Couvercle de fermeture selon l'une des revendications 1 à 3, **caractérisé en ce que**, du fait de sa fabrication, la membrane (7) est pré-incurvée vers l'espace (6) à fermer de manière étanche.

5. Couvercle de fermeture selon l'une des revendications 1 à 4, **caractérisé en ce que** la membrane (7) est configurée comme soufflet déroulant.

6. Couvercle de fermeture selon l'une des revendications 1 à 5, **caractérisé en ce que** le couvercle (9) présente au moins une ouverture (12) d'échappement d'air.

7. Couvercle de fermeture selon l'une des revendications 1 à 6, **caractérisé en ce que** le couvercle (9) est constitué d'un matériau polymère.

## Claims

1. Closure cover for the tight closure of an aperture (1) in a housing (2), comprising a supporting body (3) which is connected to at least one sealing ring (5) on the side facing the boundary wall of the aperture (1), the sealing ring (5) being formed in one piece with a diaphragm (7), in such a way as to merge into one another, for compensating for changes in volume in the space (6) which is enclosed by the housing (2) and is to be sealed off, the supporting body (3), the sealing ring (5) and the diaphragm (7) forming a unit (8) which can be preassembled, the sealing ring (5) and the diaphragm (7) being formed of the same material, the diaphragm (7) being covered by a cover (9) on the side facing away from the space (6) to be sealed off, and the cover (9) and the unit (8) being connected to one another in a frictional and/or positive-locking manner, **characterized in that** the sealing ring (5) and the diaphragm (7) are made of an elastomeric material, and the outer circumferential margin of the cover (9) can be snapped into an undercut (11) of the elastomeric material of the unit (8) which can be preassembled.

2. Closure cover according to Claim 1, **characterized in that** the supporting body (3) is made of a tough material.

3. Closure cover according to Claim 2, **characterized in that** the supporting body (3) is made of a metallic material.

4. Closure cover according to one of Claims 1 to 3, **characterized in that**, for production reasons, the diaphragm (7) is arched so as to protrude in the direction of the space (6) to be sealed off.

5. Closure cover according to one of Claims 1 to 4, **characterized in that** the diaphragm (7) is of rolling-bellows-like design.

6. Closure cover according to one of Claims 1 to 5, **characterized in that** the cover (9) has at least one vent opening (12).

7. Closure cover according to one of Claims 1 to 6, **characterized in that** the cover (9) is made of a polymer material.
